# EUROPEAN PATENT SPECIFICATION

(11) **EP 1 314 188 B1**
(45) Date of publication and mention of the grant of the patent: **27.09.2017**
(21) Application number: 01954854.4
(22) Date of filing: 23.07.2001
(51) Int. Cl.: B08B 3/08, B08B 7/00, B08B 7/02, C04B 41/91, C04B 41/00, C04B 41/53

(54) **PROCESS FOR CLEANING SEMICONDUCTOR PROCESSING COMPONENTS**
VERFAHREN ZUR REINIGUNG VON HALBLEITER-VERARBEITUNGSKOMPONENTEN
PROCEDE POUR LE NETTOYAGE DE COMPOSANTS DE TRAITEMENT DE SEMI-CONDUCTEURS

(30) Priority: 24.07.2000 US 621928
(43) Date of publication of application: 28.05.2003
(73) Proprietor: CoorsTek, Inc., Golden, CO 80403 (US)
(72) Inventor: HAERLE, Andrew, G., Sutton, Massachusetts 01590 (US)
(74) Representative: Zimmermann & Partner Patentanwälte mbB
(86) International application number: PCT/US2001/023047
(87) International publication number: WO 2002/009161

(56) References cited:
- EP-A- 0 241 749
- EP-A- 0 533 438
- WO-A-01/25167
- DE-A- 19 723 918
- GB-A- 2 130 192
- US-A- 4 543 130
- US-A- 5 081 068
- US-A- 5 294 262
- US-A- 5 846 338
- US-A- 5 967 156
- US-A- 6 004 400
- HOENIG, S.A. ET AL: "Use of dry ice and various solvents for removing flux - contaminants from printed circuit boards" ISHM '92 PROCEEDINGS. PROCEEDINGS OF THE 1992 INTERNATIONAL SYMPOSIUM ON MICROELECTRONICS (SPIE VOL. 1847), SAN FRANCISCO, CA, US, 19 - 21 October 1992, pages 29-34, XP000921023 Reston, VA, US Int. Soc. Hybrid Microelectron, US
- CHEMICAL ABSTRACTS, vol. 118, no. 16, 19 April 1993 (1993-04-19) Columbus, Ohio, US; abstract no. 152997y, KIKUCHI, KAZUMI: "Removal of chemically deposited metallic contaminants from silicon carbide ceramics" XP000391636 -& JP 04 280888 A (EAGLES INDUSTRY CO., LTD.) 6 October 1992 (1992-10-06)

## Description

### Field of the Invention

The present invention relates to a method for removing both particle impurities and chemical impurities from ceramic articles used in the manufacture of semiconductor devices.

### Background of the Invention

The manufacture of semiconductor devices typically requires subjecting the surface of a silicon wafer to high temperature processes such as diffusion, oxidation and deposition. In deposition processes, dielectric materials such as polycrystalline silicon, silicon nitride and silicon dioxide are deposited on the surface of the wafer. In diffusion processes, materials are diffused into the body of the silicon wafer. In oxidation processes, the surface of the wafer is oxidized to form a thin silica layer. Each of these processes typically involves placing the wafers to be processed in a holder, often called a "boat". The boat is typically formed of a ceramic material and is configured to hold the wafer in either a horizontal or a vertical orientation. Once loaded with wafers to be processed, the boat is placed in an electrically-heated furnace or process tube, and then the environment inside the tube is altered to provide various atmospheres having temperatures typically ranging from 250 °C to over 1200 °C.

Another common semiconductor process is etching. After a photolithographic pattern is deposited on the surface of a silicon wafer, the wafer is loaded into an etcher. The etcher, whose components are typically made of a ceramic material, uses a plasma etching process to remove the materials deposited on the wafer surface which are not protected by a photolithographic pattern. The typical etching process removes oxides, metals and/or polymers from the wafer surface.

Although each of the processes described above successfully develops the surface of the silicon wafer into a useable product, they also eventually contaminate the surfaces of the supporting equipment as well. For example, a nitride deposition process will leave a coating of silicon nitride upon not only the wafer, but also upon the surface of the boat which supported the wafer during the deposition process. When this coating becomes too thick, it tends to flake and contaminate nearby wafers with particles.

In an etching process, the deliberate removal of various layers of material from the wafer-in-process can cause contaminant particles such as silica, nitrides, and alumina to be deposited on the surface of etcher components. Since contaminants adversely affect the processing of future wafers to be processed by these components, contaminant particles must be carefully cleaned from the surfaces of these components. Because of the decreasing line widths of silicon wafers, it has become increasingly important to remove more sub-micron particles from the surface of these components, more particularly sub-micron particles having a width of no more than 0.7 microns.

Several methods for cleaning used ceramic boats are known in the prior art. In one method, a used component which is coated with a deposited material such as silicon nitride, polysilicon or silica undergoes a two-step cleaning process whereby the component is first exposed to a stream of hard pellets, such as silicon carbide pellets, in a process akin to sand-blasting, and then to a stream of frozen carbon dioxide (CO₂) pellets. The first step, termed preliminary cleaning, successfully strips deposited material from the component surface, leaving behind some debris particles on the order of one micron. In the second step, termed primary cleaning, the frozen CO₂ pellets are believed to cause the micro-sized debris particles to freeze, thereby becoming brittle, and then break, thereby allowing them to be easily flushed from the surface.

Preliminary cleaning is ordinarily carried out either by impinging or "blasting" glass, aluminum oxide, silicon carbide, titanium oxide, walnut shell particles, or other hard beads against the part being cleaned. The beads are typically carried in a pressurized stream of air or other gas. The beads can be spherical, granular, or any other desired shape and dimension. One commonly used bead material is 98% black SiC grit. The pressure under which the beads are directed to the surface depends on the composition of the part being cleaned. When a ceramic part is to be cleaned, the beads typically are applied in a gas at a pressure in the range of 1.38-2.41 bar (20-35 psi). Once completed, the bead blasting, preliminary cleaning, step is followed by a CO₂ cleaning process. CO2 cleaning processes have been described in the patent literature. See, for example, U.S. Patent No. 4,707,951, entitled "Installation for the Projection of Particles of Dry Ice", and U.S. Patent No. 6,004,400, entitled "Carbon Dioxide Cleaning Process".

US 5,846,338 describes a method for dry cleaning a wafer storage and transport pod. The pod is conditioned by purging with an ionized nitrogen gas, and cleaned with a dry aerosol spray comprised of an ionized carbon dioxide/nitrogen gas and fine particles of CO₂. US 5,967,156 describes a scheme for processing foreign material on the surface of a substrate, including providing a directed flow of a fluid, including a reactant, to the vicinity of the foreign material and delivering an aerosol of at least partially frozen particles to the foreign material. The at least partially frozen aerosol particles may include carbon dioxide. US 4,543,130 describes a cleaning apparatus for cleaning semiconductor wafers in a chamber of cleaning fluid vibrating at ultrasonic frequencies. DE 19723918 describes a cleaning apparatus for semiconductor wafers using a cleaning liquid and a drying liquid.

In another method of cleaning a used boat which is coated with deposition layers, one manufacturer recommends subjecting the used boat to an acid treatment, preferably using a strong acid such as HF, followed by baking. This HF treatment removes the deposited layer of material.

The cleanliness of virgin semiconductor processing equipment has also been a concern in the art. However, for a virgin part, the concern has typically been metallic, rather than particulate, contamination. In one conventional method of manufacturing SiC diffusion components, the virgin SiC diffusion components are subjected to a weak acid and then baked. This process serves to remove some metallic contaminants and fingerprints from the part being cleaned.

In another conventional method of insuring the cleanliness of virgin components, the component is subjected to a strong acid such as HF prior to installing it in a furnace. Similarly, hot HCl cleaning has been used in connection with semiconductor diffusion components. For example, in UK Patent Application No. GB 2,130,192, the investigators disclose a manufacturing step of subjecting a virgin SiC component to hot HCl treatments prior to use in a semiconductor furnace.

In some cases, HF treatment by itself has been considered sufficient for cleaning both virgin boats (to reduce metallic contamination) and used boats (to chemically strip coatings deposited during semiconductor processing). That notwithstanding, the use of HF alone fails to remove problematic debris particles that may still be present after such treatment.

In sum, conventional methods of providing a clean virgin semiconductor component involve acid cleaning to remove metallic contamination, while conventional methods of cleaning used components involve either i) a two-step process of mechanical stripping of deposited coats via bead blasting followed by CO₂ cleaning to remove small debris particles, or ii) hot strong acid cleaning to remove a coat of deposited material.

### Summary of the Invention

The fabrication of semiconductor devices requires the use of process components having a high level of surface purity, whether those components are new or reconditioned. In certain workpieces, such as ceramic boats used to position and maintain semiconductor wafers during processing, the long depth and narrow spacing of the wafer-retaining slots define a boat geometry with a contoured surface having an aspect ratio that prevents bead blasting from sufficiently stripping coatings from the deeper portions of these slots. In particular, aspect ratios, (i.e., the ratio of slot depth to slot width), of greater than about 4:1 are typically beyond the ability of conventional cleaning methods. The present invention presents a method for overcoming this and other shortcomings by providing a process according to claim 1.

In an example useful for understanding the invention, the chemical stripping is carried out using a solvent containing a strong acid. In a more preferred embodiment, the chemical stripping is carried out using a solvent having at least 1 v/o of an acid selected from the group consisting of HF, acids having a pKa of less than about one, and mixtures thereof. As used herein, "v/o" represents a volume percent, and "strong acid" represents a solution having at least 1 v/o of an acid having a pKa of less than about one.

Alternatively, chemical stripping may be carried out using any of a wide variety of acids. In accordance with the invention, chemical stripping is achieved using chlorinated acids. In particular, a chlorinated acid such as HCl may be applied to the surface to be cleaned prior to the CO₂ cleaning step mentioned above. While HCl is desirable due to its high level of dissociation, other chlorinated acids, including but not limited to chloroacetic acid, chloropropanic acid and chlorobenzoic acid may be used as well. Use of such acids at elevated temperatures, i.e., about 85°C and above, although not required, will result in improved surface purity. The disclosure is not intended to be limited to chlorinated acids or halogenated acids. Rather, the disclosure contemplates the use of virtually any acid that is not consisting of hydrofluoric and that is capable of stripping contaminants from the substrate surface. While not a requirement, employing such acids at the elevated temperatures described above is believed to result in improved surface purity.

In an example useful for understanding the invention, liquid acid treatment may be replaced by gas-phase chemical stripping agents. For example, prior to the CO₂ cleaning step, surfaces to be cleaned may be treated with a halogen gas or a gas containing halogenated compounds. Thus, the chemical stripping step may be carried out by exposing the surface to gas phase chlorine, fluorine, bromine, iodine, etc., or it may be exposed to a gas-phase chlorinated compound such as SiCl₄. Gas-phase halogenated organic compounds may be used as well. These include, but are not limited to 1,1,1-trichloroethane (TCA) and 1,2-trans-dichloroethylene (DCE).

In an embodiment of the invention, the use of supercritical fluids as chemical stripping agents is contemplated as well. Supercritical fluids are dense gasses that are maintained at temperatures above their critical temperature (i.e., the temperature above which the gas can no longer be liquified by pressure). Because supercritical fluids are less viscous and diffuse more rapidly than liquids, they are expected to offer excellent results in chemical stripping applications.

The CO₂ cleaning step employs particles of dry ice which are projected against the surface being cleaned. The combination of the chemical stripping and the CO₂ cleaning step has been found to successfully remove both particulate and metallic contaminants from the surface of the workpiece.

Workpieces cleaned using the inventive process have been found to have a surface contaminant particle density of no more than about 0.4 particles, and preferably no more than about 0.2 particles, larger than about 0.3 µm per square centimeter. Such workpieces have also been found to have a surface metallic contaminant concentration of no more than about 600 ppm, as measured by SIMS at a depth of about 10 nm. Of the surface metallic contamination, no more than about 400 ppm of metal contaminants other than alkaline and alkaline earth metals, and no more than about 225 ppm of iron, (as measured by SIMS at a depth of about 10 nm), remain following application of the inventive cleaning process to typical workpieces.

One aspect of the present invention is based upon the recognition that problematic debris particles may still be present after chemical stripping, and that CO₂ cleaning steps, while removing particulate contaminants, are unable to remove non-particulate surface metallic contaminants. The present invention employs chemical stripping to remove surface metallics followed by a CO₂ cleaning step to remove any remaining debris particles. Combining a CO₂ cleaning step with chemical stripping is unique in that CO₂ cleaning has traditionally been used after a used workpiece underwent mechanical stripping which produced debris particles.

According to examples
useful for understanding the present invention, methods other than the CO₂ cleaning step may be used to remove particulate debris from the workpiece surface. For example, cleaning may be achieved using sonic energy instead of or in addition to the CO₂ cleaning step. The sonic energy may be applied as ultrasonic or megasonic energy. Megasonic cleaning is related to ultrasonic cleaning in that it uses sound waves in the cleaning process, however, unlike the frequencies employed in ultrasonic cleaning, (approximately 50-250 kHz), megasonic cleaning methods employ frequencies in the range of approximately 700-1000 kHz.

Examples useful for understanding
the present invention also relate to workpieces, such as ceramic boats used in semiconductor processing, that have been cleaned using the process of the present invention. The resulting workpieces are unique in that their level of metallic and particulate surface contamination is significantly below that which has previously been obtainable using processes known to those skilled in the art.

### Detailed Description of the Invention

The present invention provides a process for providing ceramic workpieces, such a ceramic boats used in semiconductor fabrication with a lower level of metallic and particulate surface contamination than has previously been available. Specifically, whereas it is known in the art to use acid cleaning, and whereas it is also known in the art to use bead-blast cleaning in combination with CO₂ cleaning, to date, there has been no suggestion in the art to combine a chemical stripping step with a CO₂ cleaning step for cleaning either virgin or used, coated ceramic workpieces. The recognition that a chemical stripping step can be combined with a CO₂ cleaning step yields a cleaning process that is well-suited for use with both virgin and used, coated workpieces.

As noted above, use of the inventive process has provided workpieces having a surface contaminant particle density of no more than about 0.4 particles larger than about 0.3 µm per square centimeter, and a surface metallic contaminant concentration of no more than about 600 ppm, as measured by SIMS at a depth of about 10 nm.

Traditionally, upon receiving a virgin workpiece such as a ceramic boat from a manufacturer, the user would subject the workpiece to an acid cleaning process in order to remove any metallic contaminants that may have deposited on the workpiece during manufacture, packaging, shipping, etc. In some instances, used, coated workpieces would be cleaned by chemical stripping using a strong acid. As with the virgin workpieces, the acid cleaning provided a satisfactory means for removing metallic contaminants form the surface of the workpiece.

Although chemical stripping provides a surface having metallic contaminants lowered to satisfactory levels, the process fails to provide a surface having a sufficiently low level of particulate contamination. In fact, some evidence exists that the chemical stripping step actually contributes to particulate contamination. Without wishing to be tied to any particular theory, in cleaning a workpiece such as a used ceramic boat, workpieces cleaned using chemical stripping to remove a coating still have a high level of particulate contamination because the stripping process leaves particulate contaminants on the ceramic surface.

Furthermore, particulate contamination does not result solely from the chemical stripping process and post-processing steps. Rather, in the case of virgin workpieces, it is believed that machining the component, such as an SiC boat, produces particles which deposit upon the surface of the component. Of course, particles also may deposit upon a virgin component because of exposure of such components to non-clean-room environments. It should be noted that, in the case of either virgin or used components, and pre-processing, processing or post-processing steps, many mechanisms for the formation of particles on the workpiece may exist, and the present invention is not intended to be limited to any particular particle formation or deposition mechanism.

As noted previously, CO₂ cleaning procedures have traditionally been used in combination with a preliminary cleaning step such as bead-blasting. The combination of bead-blasting and CO₂ cleaning has generally not been used on virgin workpieces, but rather, has been employed on used workpieces that have had CVD coatings deposited on their surfaces during semiconductor processing. While this method has been found to be satisfactory for the removal of particulate contaminants, it lacks the ability to remove metallic contamination that occurs on both virgin and used workpieces.

The present invention recognizes that until the workpiece, be it a virgin component or a chemically-stripped component, is subjected to a final CO₂ cleaning step, problematic submicron particles which need to be eliminated from the surface of the components will remain. The need for removal of such particulate contaminants, as well as the manner in which such removal is achieved is neither appreciated nor performed in conventional processes.

Moreover, it appears that products resulting from the inventive process also possess superior levels of metallic purity as compared to re-worked products processed by cleaning methods which use CO₂ cleaning to clean the used coated workpieces. As noted above, one conventional process mechanically strips the coating from a used component, such as a boat, via bead blasting, and then uses CO₂ cleaning to complete the cleaning. Without wishing to be tied to any particular theory, in the case of a used boat, the conventional understanding is that surface metallic contamination is not a problem. Conversely, even if surface metallic contamination did give rise to problems, it was wrongly assumed that such problems could be sufficiently eliminated using techniques known in the prior art.

In contrast, some evidence suggests that a bead blasting step actually acts to increase the concentration of metallic impurities at the surface of the workpiece. This undesirable effect may be the result of the use of impure blasting media.

The process of the present invention is superior to the conventional bead blasting/CO₂ cleaning process in that it does not result in metallic contamination of the surface of the stripped workpiece. In fact, the present inventive process acts to reduce the concentration of metals at the surface.

Likewise, for a virgin workpiece, such as an unused SiC boat, the conventional understanding of surface metallic impurity has been that HF or hot HCl cleaning offered only marginal utility because it served only to incrementally reduce the concentration of metals at the surface of the component to a level slightly below that of the bulk material forming the workpiece (1-10 ppm for SiC), and that this relative purity advantage over the bulk disappeared over time as subsequent use under high temperature environments promoted the diffusion of bulk metals into the surface region of the component. Accordingly, the art did not require chemical stripping in all circumstances.

The surface of materials representing virgin SiC components has been analyzed by one conventional method (x-ray photoelectron spectroscopy, referred to herein as XPS) and by another method (secondary ion mass spectroscopy, referred to herein as SIMS). A conventional XPS analysis provides information at a depth of about 3 nm and has a sensitivity of about 0.1-1.0% depending upon the element of interest. In contrast, the SIMS analysis can provide information at a depth of about 10 nm and has a sensitivity of about 0.2-3.0 ppm. For this reason, the SIMS test provides a more accurate method for measuring the surface concentration of metals in semiconductor processing components. It has been found that in instances where XPS failed to detect any metals, (and thus failed to provide any indication of an elevated surface metals concentration), the SIMS test reported about 2000 ppm metals at a depth of 10 nm. In the field of high temperature semiconductor processing, these surface levels are clearly undesirable. Accordingly, as a result of the SIMS analysis, there is now a demonstrated need to clean the surface of a virgin ceramic component, preferably using a chemical stripping step, in order to reduce the high surface level of metallic contaminants present at the surface of semiconductor processing components. It should be appreciated that, in one embodiment of the present invention, the surface is a CVD surface, which optionally may have been subjected to machining or other post-processing steps.

As outlined above, the chemical stripping step can employ a wide variety of chemical stripping agents. In particular, it may be a solvent having at least 1 v/o of an acid selected from the group consisting of HF, acids having a pKa of less than about one, and mixtures thereof. In accordance with the invention, the chemical stripping agent is selected from the class of chlorinated acids. In particular, a chlorinated acid such as HCl can be used. Although HCl is desirable due to its high level of dissociation, other chlorinated acids, including but not limited to chloroacetic acid, chloropropanic acid and chlorobenzoic acid may also be used. In one preferred embodiment, the chemical stripping step is carried out at elevated temperatures, i.e., about 85°C and above, as such temperatures have been found to result in improved surface purity.

As also noted, chemical stripping may be carried out using gas-phase chemical stripping agents. Exemplary gas-phase chemical stripping agents include halogen gasses and gasses containing halogenated compounds. Thus, chemical stripping may be achieved using gas phase chlorine, fluorine, bromine, iodine, etc., or gas-phase chlorinated compounds such as SiCl₄. Gas-phase halogenated organic compounds may be used as well. As noted previously, these include, but are not limited to 1,1,1-trichloroethane (TCA) and 1,2-trans-dichloroethylene (DCE).

More particularly, it should be understood that the process of the present invention is intended to be applied to a wide variety of inorganic surfaces employed by semiconductor processing components comprising SiC. Such surfaces typically comprise ceramic materials such as those ceramics commonly used in semiconductor fabrication, however, the process may be applied to non-ceramic surfaces such as silicon and diamond as well. Thus, while the discussion has focused primarily on semiconductor processing components such as ceramic boats, and particularly those formed of SiC, it should be understood that the invention is not intended to be limited in this manner. Rather, the invention is intended to apply to any of the semiconductor processing components comprising SiC that have inorganic surfaces associated with semiconductor wafer processing techniques. These surfaces include, but are not limited to silicon (Si), silicon carbide (SiC), silicon nitride (Si₃N₄), diamond, yttria (Y₂O₃), zirconia (ZrO₂), aluminum nitride (AlN), aluminum oxide (Al₂O₃), graphite and polycrystalline or fused quartz.

The surfaces may be vapor-deposited, and as discussed above may be deposited using CVD techniques. Such surfaces include, but are not limited to polycrystalline or other CVD Si, CVD SiC, CVD SiO₂, CVD Si₃N₄ and CVD diamond surfaces. Of course, it should be understood that despite the applicability of the present invention to surfaces having inorganic coatings thereon, the process may also be applied to uncoated, inorganic surfaces.

In considering SiC workpieces, several varieties are used in the art. In one embodiment, a workpiece formed simply of SiC is used. In another embodiment, the workpiece comprises a reduced porosity SiC formed by loading the pores of a SiC structure with Si. Because the silicon tends to escape from the pores, such workpieces are often provided with a CVD SiC layer. More specifically, these components typically are formed of a porous α-SiC body having Si occupying the pores. To prevent the Si from escaping, a layer of very pure β-SiC is deposited on the surface of the component using CVD methods. The β-SiC is intended to seal the surface and inhibit loss of Si near the surface of the workpiece.

It should be understood that the β-SiC material deposited on the workpiece to prevent Si from escaping is not intended to be removed by the process of the present invention. Rather, when referring herein to the removal of coatings from used workpieces, the subject coatings are those that have been deposited on the workpiece during its use in semiconductor processing. Thus, a virgin coated workpiece refers to a newly manufactured workpiece having a desired coating formed thereon, while a used, coated workpiece refers to a workpiece having an undesired coating deposited during semiconductor processing. Of course, upon use, the virgin coated workpiece acquires an additional, undesired coating, and it is the removal of the coating which forms one embodiment of the present invention.

While useful with vertical racks, it should be understood that the process of the present invention employing a chlorinated acid clean followed by a CO₂ clean provides unexpected benefits not only for vertical racks, but also for semiconductor processing equipment of any shape. Examples of semiconductor processing components used in single wafer processing to which the present invention may be applied include, but are not limited to, bell jars, electrostatic chucks, focus rings, shadow rings, chambers, susceptors, lift pins, domes, end effectors, liners, supports, injector ports, manometer ports, wafer insert passages, screen plates, heaters, and vacuum chucks. Examples of semiconductor processing components used in batch processing to which the present invention may be applied include, but are not limited to, paddles, process tubes, wafer boats, liners, pedestals, long boats, and dummy wafers. Examples of semiconductor processing components used in chemical mechanical polishing (CMP) to which the present invention may be applied include, but are not limited to, conditioning pads and wafer holders.

Lastly, it is believed that the process of the present invention provides for the first time a ready-to-install product, that is, a product that can be safely taken out of a protective shipping bag at the user's facility and directly installed in a semiconductor furnace without any further cleaning by the user. This is achievable because such components already have the lowest possible amounts of surface metals and particles achievable by surface treatments.

More particularly, in accordance with the present invention, immediately upon completing the CO₂ cleaning step, the cleaned workpiece is installed either into a furnace used for processing semiconductor wafers, or into a bag used for the shipping and storage of cleaned semiconductor processing components. In the former process, the workpiece is transferred directly from CO₂ cleaning into the furnace without any further cleaning steps. In the latter process, the workpiece is packaged, i.e., placed into a sealable container such as a bag and sealed, directly following CO₂ cleaning without any further cleaning steps. In this latter case, upon removing the workpiece from its packaging, it is installed directly into a furnace used for processing semiconductor wafers without any further cleaning steps. Unlike processes known in the art in which it is necessary to provide additional cleaning steps between removal of the workpiece from its packaging and installation in the furnace, components cleaned using the method of the present invention may be installed into the furnace immediately upon removal from their packaging. This is advantageous in that it eliminates additional processing steps which can, among other things, actually lead to increased levels of contamination, particularly particulate contamination.

In certain circumstances, those using the cleaned components of the present invention have a need to provide additional surface coatings on a workpiece prior to installing it in semiconductor processing equipment. For example, it may be desirable to deposit a polysilicon layer, a silicon oxide layer, a silicon nitride layer, a metallic layer, a photoresist layer or some other layer upon the workpiece prior to using that workpiece in a semiconductor fabrication process. Typically, the semiconductor manufacturer must deposit or otherwise lay down that layer upon the workpiece once it has been removed from any packaging. This process, however, has the potential of introducing contaminants to the workpiece surface. The present invention, however, eliminates this problem by providing the workpiece with one or more desired layers on its surface immediately after the cleaning process has been carried out, and immediately before packaging the workpiece for shipping or storage. Thus, the present invention is a process in which, upon completion of the CO₂ step, one or more coating layers are provided onto the workpiece surface. Optionally, once said one or more additional coating layers have been provided on the workpiece, a second cleaning employing a chemical stripping step and a CO₂ step, of the types described above may be applied to the coated workpiece prior to packaging.

In certain circumstances, such as when using virgin workpieces, removal of particulate contaminants may not be needed. Thus, in an example useful for understanding the invention, the workpiece is chemically stripped as described above, provided with an additional surface coating such as a polysilicon layer, a silicon oxide layer, a silicon nitride layer, a metallic layer, a photoresist layer, or some other layer, and then either packaged or placed directly in semiconductor processing equipment for immediate use. This example offers the advantage of providing a cleaned, coated workpiece that can be used immediately upon removal from its packaging without the need for additional cleaning or coating steps in the semiconductor processing equipment.

Purity may be further enhanced by performing any or all of the processing steps in a clean-room environment. Thus, the workpiece may be processed entirely in a clean-room environment from the initial chemical stripping step, or it may be moved to such an environment prior to the CO₂ step, the optional coating step, the optional final chemical stripping step, or the optional CO₂ step.

Although several prior art cleaning regimes, and their advantages and disadvantages, have been described previously herein, none of those known in the art offer the ability to provide a surface having the low contamination level of metallics and particles available from the inventive process described herein. Simply washing in a strong acid solution, such as a solution containing HF or other acid having a pKa of less than about one, provides a surface having unsatisfactory levels of particulate contaminants. Alternatively, simply washing in a weak acid solution or bead-blasting followed by a CO₂ cleaning results in less desirable levels of metallic contaminants. It was not until the present invention, in which chemical stripping is followed by CO₂ cleaning, that one could achieve acceptable levels of both metallic and particulate contamination.

In an embodiment of the present invention, the chemical stripping and CO₂ cleaning steps are coupled with a modified high-purity bead blasting step. Specifically, in this embodiment, the invention includes the steps of bead-blasting the surface of the workpiece using green SiC particles. Subsequently, the surface is contacted with a solvent having at least 1 v/o of an acid selected from the group consisting of HF, acids having a pKa of less than about one, and mixtures thereof. The surface is then treated using CO₂ cleaning. The use of green SiC in the bead-blasting step is unique in that, to date, only black SiC has been used for bead-blasting purposes. In the present invention it has been found that bead-blasting using green SiC beads provides surfaces that are significantly lower in contaminants. This is believed to be the result of the composition of the black SiC beads versus the green SiC beads. Whereas the former comprise a grit containing about 98% SiC, (and an impurity level of about 2%), the latter contain impurities in the range of approximately 1000-2000 parts per million, (i.e., 0.1-0.2% impurities).

In still another example useful for understanding the present invention, the chemical stripping step can be eliminated entirely and replaced with a bead blasting step using green SiC beads described above. Thus, the process employs the steps of bead-blasting with green SiC followed by a CO₂ cleaning.

In yet another example useful for understanding the present invention, use of a chemical stripping step can be eliminated when cleaning certain components. Specifically, as noted above, certain workpieces may be provided with coatings. Such coatings may be provided by any of a wide variety of processes including chemical vapor deposition, sputter deposition and spray coating. For example, a workpiece formed of α-SiC may be provided with a CVD deposited β-SiC coating to form a very pure surface. Likewise, thick CVD deposited SiC films of up to about 500 microns in thickness usually do not require additional machining steps, and thus avoid one significant source of metallic contamination. Alternatively, workpieces formed from other ceramic materials may be such that they do not require certain processing steps, such as sandblasting, that introduce metallic impurities onto the ceramic surface. These workpieces also have surfaces that are low in metallic contaminants. New workpieces having such coated or otherwise pure surfaces are relatively free of metallic contaminants. Of course, any of the surfaces described above will include some low level of unavoidable metallic impurities, however, such impurity levels are significantly lower than those introduced by machining steps such as sandblasting. As such, these workpieces can be cleaned using only the CO₂ process and installed directly into a furnace or immediately packaged without any additional cleaning steps. Likewise, the packaged workpieces of this type can be removed from their packaging and directly installed into a furnace without any additional cleaning steps. Thus, although the prior art includes processes in which the CO₂ process is used without a chemical stripping step, none of these processes are used in connection with virgin workpieces of the type described above. By eliminating the chemical stripping step for certain virgin workpieces, cleaning time and process complexity can be minimized.

It is noted that in each of the embodiments employing green SiC described above, the CO₂ cleaning step may employ techniques and apparatus that are known in the art. One example of a satisfactory CO₂ method and delivery system is that described in U.S. Patent 6 004 400, entitled "Carbon Dioxide Cleaning Process".

Further improvements include the use of high purity CO₂ in the CO₂ cleaning step and the application of the present process, to the extent possible, in a clean-room environment. Needless to say, any reduction in impurities in the environment surrounding the workpiece during or after cleaning will result, ultimately, in a cleaner workpiece.

### Examples

Results are presented below for several tests of the steps used in the process. In Table 1, CVD SiC coated parts that had been subjected to machining (i.e., wet or dry sandblasting) were analyzed for metallic impurities. These samples were measured either directly after the sandblasting, after a post-sandblasting weak acid treatment, or after the samples had been subjected to the process (HF/CO₂) post-sandblasting. The ability of the process to provide improved metal removal, particularly for iron can be seen in the Table.

**TABLE 1- Metallic Impurities in Parts Per Million**

| **PROCESS** | **Na** | **Al** | **Ti** | **V** | **Cr** | **Fe** | **Ni** |
|---|---|---|---|---|---|---|---|
| WS | 6 | 54 | 3 | 0.5 | 14 | 115 | 2 |
| WS weak acid | 6 | 33 | 1 | 0.1 | 8 | 38 | 0.8 |
| WS Invention | 2 | 17 | 1 | 0.05 | 6 | 28 | 2 |
| DS | 136 | 98 | 60 | 10 | 4 | 1441 | 18 |
| DS weak acid | 132 | 60 | 39 | 7 | 3 | 381 | 8 |
| DS Invention | 7 | 107 | 20 | 3 | 4 | 211 | 4 |

WS = Wet Sandblast
DS = Dry Sandblast

Results from SIMS approximately 10 nm below surface.

Table 2 presents particulate impurity data for non-machined samples that do not have CVD coated surfaces. Samples 1-6 were treated with conventional workpiece cleaning steps, and samples 7-10 were cleaned using the process of the present invention. The numbers of particulate impurities are presented for two sides of each sample.

**TABLE 2 - Particulate Impurities I**

| **Sample** | **Process** | **Side 1** | **Side 2** |
|---|---|---|---|
| 1 | Conventional | 0.98 | 1.12 |
| 2 | Conventional | 0.8 | 0.67 |
| 3 | Conventional | 0.77 | 0.78 |
| 4 | Conventional | 0.99 | 0.86 |
| 5 | Conventional | 1.34 | 1.23 |
| 6 | Conventional | 0.79 | 0.86 |
| 7 | CO₂ | 0.03 | 0.17 |
| 8 | CO₂ | 0.14 | 0.12 |
| 9 | CO₂ | 0.05 | 0.03 |
| 10 | CO₂ | 0.04 | 0.12 |

Table 3 presents particulate impurity data for samples before and after treatment with the CO₂ process described above. In samples A, B and C, the sample is machined SiC that does not have a CVD coating on its surface. Sample D is a non-machined sample having a CVD SiC surface. As can be seen, the use of the CO₂ process significantly reduces the amount of particulate contaminants.

**TABLE 3 - Particulate Impurities II**

| **Sample** | **Particles Before** | **Particles After** |
|---|---|---|
| A | 0.35 | 0.04 |
| B | 0.54 | 0.13 |
| C | 0.55 | 0.09 |
| D | 0.65 | 0.01 |

### Equivalents

From the foregoing detailed description of the specific embodiments of the invention, it should be apparent that a novel process for removing metallic and particulate contaminants from ceramic workpieces has been described. Although particular embodiments have been disclosed herein in detail, this has been done by way of example for purposes of illustration only, and is not intended to be limiting with respect to the scope of the appended claims which follow. In particular, it is contemplated by the inventors that various substitutions, alterations, and modifications may be made to the invention without departing from the scope of the invention as defined by the claims.

## Claims

1. A process for cleaning a semiconductor processing component comprising SiC, the semiconductor processing component having an inorganic surface, the process comprising the steps of:
a) exposing the inorganic surface to a chemical stripping agent, wherein the chemical stripping agent comprises a chlorinated acid,
b) directing a flow of frozen CO₂ pellets upon the inorganic surface,
c) depositing at least one additional material layer on the inorganic surface, and
d1) installing the semiconductor processing component in a furnace for processing semiconductor wafers or
d2) sealing the semiconductor processing component in a package suitable for storage and transport,
wherein the at least one additional material layer is deposited on the inorganic surface after completing the flow of frozen CO₂ pellets and either prior to installing the component in the furnace or prior to packaging the semiconductor processing component.

2. The process of claim 1, wherein the chlorinated acid is selected from the group consisting of HCl, chloroacetic acid, chloropropanic acid, chlorobenzoic acid, and mixtures thereof.

3. The process of claim 1, wherein the chemical stripping agent comprises a gas phase chemical stripping agent.

4. The process of claim 3, wherein the chemical stripping agent comprises a halogen or halogenated compound, and wherein the halogen is preferably selected from the group consisting of chlorine, fluorine, bromine and iodine, the halogenated compound preferably comprises SiCl₄, or wherein the halogenated compound preferably is a halogenated organic compound, preferably selected from the group consisting of 1,1,1-trichloroethane, 1,2-trans-dichloroethylene and mixtures thereof.

5. The process of claim 1, wherein the chemical stripping step is carried out at a temperature above room temperature, preferably at a temperature of at least about 85°C.

6. The process according to claim 1, wherein the inorganic surface is exposed to the chemical stripping agent for a time sufficient to provide the inorganic surface with a metallic contaminant concentration of at most about 600 ppm, as measured by SIMS at a depth of about 10 nm.

7. The process according to claim 1, wherein the inorganic surface is exposed to the chemical stripping agent for a time sufficient to provide a surface concentration of metal contaminants other than alkaline and alkaline earth metals of at most about 400 ppm, as measured by SIMS at a depth of about 10 nm.

8. The process according to claim 1, wherein the inorganic surface is exposed to the chemical stripping agent for a time sufficient to provide the inorganic surface with an iron contaminant concentration of at most about 225 ppm, as measured by SIMS at a depth of about 10 nm.

9. The process of claim 1, wherein the chemical stripping agent comprises a supercritical fluid.

10. The process according to claim 1, wherein the surface is exposed to the flow of frozen CO₂ pellets for a time sufficient to provide a surface particulate contamination of at most about 0.4 particles larger than about 0.3 µm per square centimeter.

11. The process of claim 1, wherein no additional cleaning steps are carried out between completing the flow of frozen CO₂ pellets and either installing the semiconductor processing component in the furnace or packaging the semiconductor processing component.

12. The process of claim 1, wherein said at least one additional material layer comprises a polysilicon layer, a silicon oxide layer, a silicon nitride layer, a metallic layer, a photoresist layer, and combinations thereof.

13. The process of claim 1, wherein after said at least one additional material layer is deposited on the inorganic surface, the deposited layer is subjected to a process comprising the steps of:
a) exposing said at least one additional material layer to a chemical stripping agent, and
b) directing a flow of frozen CO₂ pellets upon the inorganic surface.

14. The process of claim 1, wherein the semiconductor processing component is sealed in the package suitable for storage and transport, and which further includes removing the component from the package and installing the semiconductor processing component into a furnace used for processing semiconductor wafers.

15. The process of claim 14 wherein no additional cleaning steps are carried out between removing the semiconductor processing component from the package and installing it into the furnace.

16. The process according to claim 1, wherein prior to the step of exposing the inorganic surface to the chemical stripping agent, the component is subjected to blasting with green SiC.

17. The process according to claim 1, wherein the inorganic surface is selected from the group consisting of Si, diamond, Y₂O₃, ZrO₂, SiC, Si₃N₄, AlN, Al₂O₃ and polycrystalline or fused quartz.

18. The process according to claim 1, wherein the inorganic surface has a vapor-deposited coating thereon, and wherein the vapor-deposited material is preferably selected from the group consisting of CVD Si, CVD SiO₂, CVD SiC, CVD Si₃N₄, CVD diamond, Y₂O₃ and ZrO₂.

19. The process of claim 1, wherein the inorganic surface comprises a coating provided by sputter deposition or spray coating.

20. The process of claim 1, wherein after providing said at least one additional material layer, no additional cleaning steps are carried out before the component is installed in the furnace used for processing semiconductor wafers.

21. The process of claim 1, wherein no additional cleaning steps are carried out between providing said at least one additional material layer and packaging the semiconductor processing component.

22. The process of claim 1, wherein the semiconductor processing component comprises a porous SiC structure loaded with Si.

23. The process of claim 22, wherein the semiconductor processing component is provided with a SiC layer deposited by CVD methods.

## Patentansprüche

1. Ein Verfahren zur Reinigung einer Halbleiterverarbeitungs-Komponente, die SiC umfasst, wobei die Halbleiterverarbeitungs-Komponente eine anorganische Oberfläche aufweist, und wobei das Verfahren die Schritte umfasst:
a) Aussetzen der anorganischen Oberfläche an ein chemisches Abbeizmittel, wobei das chemische Abbeizmittel eine chlorierte Säure enthält,
b) Richten eines Stroms von gefrorenen CO₂ Pellets auf die anorganische Oberfläche,
c) Abscheiden wenigstens einer zusätzlichen Materialschicht auf der anorganischen Oberfläche, und
d1) Installieren der Halbleiterverarbeitungs-Komponente in einem Ofen zur Bearbeitung von Halbleiterwafern, oder
d2) Einschließen der Halbleiterverarbeitungs-Komponente in eine für Lagerung und Transport geeignete Verpackung,
wobei die wenigstens eine zusätzliche Materialschicht auf der anorganischen Oberfläche abgeschieden wird, nachdem der Strom von gefrorenen CO₂ Pellets abgeschlossen ist, und entweder vor dem Installieren der Komponente in dem Ofen oder vor dem Verpacken der Halbleiterverarbeitungs-Komponente.

2. Das Verfahren gemäß Anspruch 1, wobei die chlorierte Säure aus der Gruppe, die aus HCl, Chloressigsäure, Chlorpropansäure, Chlorbenzoesäure und Mischungen davon besteht, ausgewählt ist.

3. Das Verfahren gemäß Anspruch 1, wobei das chemische Abbeizmittel ein chemisches Gasphasen-Abbeizmittel umfasst.

4. Das Verfahren gemäß Anspruch 3, wobei das chemische Abbeizmittel eine Halogen-oder halogenierte Verbindung umfasst, und wobei das Halogen vorzugsweise aus der Gruppe, die aus Chlor, Fluor, Brom und Jod besteht, ausgewählt ist, die halogenierte Verbindung vorzugsweise SiCl₄ enthält, oder wobei die halogenierte Verbindung vorzugsweise eine halogenierte organische Verbindung ist, die vorzugsweise aus der Gruppe ausgewählt ist, die aus 1,1,1-Trichlorethan, 1,2-trans-Dichlorethylen und Mischungen davon besteht.

5. Das Verfahren gemäß Anspruch 1, wobei der Schritt des chemischen Abbeizens bei einer Temperatur oberhalb von Raumtemperatur durchgeführt wird, vorzugsweise bei einer Temperatur von wenigstens etwa 85°C.

6. Das Verfahren gemäß Anspruch 1, wobei die anorganische Oberfläche dem chemischen Abbeizmittel für eine hinreichend lange Zeit ausgesetzt wird, um die anorganische Oberfläche mit einer metallischen Verunreinigungs-Konzentration von höchstens etwa 600 ppm, gemessen mit SIMS in einer Tiefe von etwa 10 nm, zu versehen.

7. Das Verfahren gemäß Anspruch 1, wobei die anorganische Oberfläche dem chemischen Abbeizmittel für eine hinreichend lange Zeit ausgesetzt wird, um eine Oberflächenkonzentration von metallischen Verunreinigungen, die andere als Alkali- und Erdalkalimetalle sind, von höchstens etwa 400 ppm, gemessen mit SIMS in einer Tiefe von etwa 10 nm, bereitzustellen.

8. Das Verfahren gemäß Anspruch 1, wobei die anorganische Oberfläche dem chemischen Abbeizmittel für eine hinreichend lange Zeit ausgesetzt wird, um die anorganische Oberfläche mit einer Eisen-Verunreinigungs-Konzentration von höchstens etwa 225 ppm, gemessen mit SIMS in einer Tiefe von etwa 10 nm, zu versehen.

9. Das Verfahren gemäß Anspruch 1, wobei das chemische Abbeizmittel ein überkritisches Fluid enthält.

10. Das Verfahren gemäß Anspruch 1, wobei die Oberfläche dem Strom von gefrorenen CO₂ Pellets für eine hinreichend lange Zeit ausgesetzt wird, um eine teilchenförmige Oberflächenverunreinigung von höchstens etwa 0.4 Partikel größer als etwa 0.3 µm pro Quadratzentimeter zu erzeugen.

11. Das Verfahren gemäß Anspruch 1, wobei keine zusätzlichen Reinigungsschritte zwischen dem Abschluss des Stroms von gefrorenen CO₂ Pellets und entweder der Installation der Halbleiterverarbeitungs-Komponente im Ofen oder dem Verpacken der Halbleiterverarbeitungs-Komponente durchgeführt werden.

12. Das Verfahren gemäß Anspruch 1, wobei die wenigstens eine zusätzliche Materialschicht eine Polysiliziumschicht, eine Siliziumoxidschicht, eine Siliziumnitridschicht, eine Metallschicht, eine Photoresistschicht und Kombinationen davon umfasst.

13. Das Verfahren gemäß Anspruch 1, wobei, nachdem die wenigstens eine zusätzliche Materialschicht auf der anorganischen Oberfläche abgeschieden wurde, die abgeschiedene Schicht einem Verfahren unterzogen wird, das die folgenden Schritte umfasst:
a) Aussetzten der wenigstens einen zusätzlichen Materialschicht an ein chemisches Abbeizmittel, und
b) Richten eines Stroms von gefrorenen CO₂ Pellets auf die anorganische Oberfläche.

14. Das Verfahren gemäß Anspruch 1, wobei die Halbleiterverarbeitungs-Komponente in eine für Lagerung und Transport geeignete Verpackung eingeschlossen ist, und das weiter ein Entfernen der Komponente aus der Verpackung und das Installieren der Halbleiterverarbeitungs-Komponente in einem Ofen, der zur Bearbeitung von Halbleiterwafern verwendet wird, umfasst.

15. Das Verfahren gemäß Anspruch 14, wobei keine zusätzlichen Reinigungsschritte zwischen dem Entfernen der Halbleiterverarbeitungs-Komponente aus der Verpackung und ihrer Installation im Ofen durchgeführt werden.

16. Das Verfahren gemäß Anspruch 1, wobei die Komponente vor dem Schritt des Aussetzens der anorganischen Oberfläche an das chemische Abbeizmittel mit grünem SiC abgestrahlt wird.

17. Das Verfahren gemäß Anspruch 1, wobei die anorganische Oberfläche aus der Gruppe ausgewählt ist, die aus Si, Diamant, Y₂O₃, ZrO₂, SiC, Si₃N₄, AlN, Al₂O₃ und polykristallinem oder geschmolzenem Quarz besteht.

18. Das Verfahren gemäß Anspruch 1, wobei die anorganische Oberfläche eine aufgedampfte Beschichtung darauf aufweist, und wobei das aufgedampfte Material vorzugsweise aus der Gruppe ausgewählt ist, die aus CVD Si, CVD SiO₂, CVD SiC, CVD Si₃N₄, CVD Diamant, Y₂O₃ und ZrO₂ besteht.

19. Das Verfahren gemäß Anspruch 1, wobei die anorganische Oberfläche eine Beschichtung umfasst, die durch Sputterabscheidung oder Sprühbeschichtung bereitgestellt wird.

20. Das Verfahren gemäß Anspruch 1, wobei nach dem Bereitstellen der wenigstens einen zusätzlichen Materialschicht keine weiteren Reinigungsschritte durchgeführt werden bevor die Komponente im Ofen zur Bearbeitung von Halbleiterwafern installiert wird.

21. Das Verfahren gemäß Anspruch 1, wobei keine zusätzlichen Reinigungsschritte zwischen dem Bereitstellen der wenigstens einen zusätzlichen Materialschicht und dem Verpacken der Halbleiterverarbeitungs-Komponente durchgeführt werden.

22. Das Verfahren gemäß Anspruch 1, wobei die Halbleiterverarbeitungs-Komponente eine poröse SiC Struktur umfasst, die mit Si beladen ist.

23. Das Verfahren gemäß Anspruch 22, wobei die Halbleiterverarbeitungs-Komponente mit einer SiC Schicht versehen wird, die mit CVD Verfahren abgeschieden wird.

## Revendications

1. Procédé pour le nettoyage d'un composant de traitement de semi-conducteurs comprenant du SiC, le composant de traitement de semi-conducteurs présentant une surface inorganique, le procédé comprenant les étapes consistant à:
a) exposer la surface inorganique à un agent de décapage chimique, où l'agent de décapage chimique comprend un acide chloré,
b) diriger un flux de pastilles de CO₂ congelées vers la surface inorganique,
c) déposer au moins une couche de matériau additionnelle sur la surface inorganique, et
d1) installer le composant de traitement de semi-conducteurs dans un four pour le traitement de plaquettes semi-conductrices, ou
d2) placer de manière étanche le composant de traitement de semi-conducteurs dans un emballage convenant pour l'entreposage et le transport,
dans lequel l'au moins une couche de matériau additionnelle est déposée sur la surface inorganique après avoir terminé le flux de pastilles de CO₂ congelées et soit avant d'installer le composant dans le four, soit avant d'emballer le composant de traitement de semi-conducteurs.

2. Procédé selon la revendication 1, dans lequel l'acide chloré est choisi dans le groupe composé de HC1, d'acide chloracétique, d'acide chloropropanique, d'acide chlorobenzoïque et de mélanges de ces derniers.

3. Procédé selon la revendication 1, dans lequel l'agent de décapage chimique comprend un agent de décapage chimique en phase gazeuse.

4. Procédé selon la revendication 3, dans lequel l'agent de décapage chimique comprend un halogène ou un composé halogéné, et dans lequel l'halogène est de préférence choisi dans le groupe composé de chlore, de fluor, de brome et d'iode, le composé halogéné comprend de préférence SiC1₄, ou dans lequel le composé halogéné est de préférence un composé organique halogéné, de préférence choisi dans le groupe composé de 1,1,1-trichloroéthane, 1,2-trans-dichloroéthylène et de mélanges de ces derniers.

5. Procédé selon la revendication 1, dans lequel l'étape de décapage chimique est réalisée à une température supérieure à la température ambiante, de préférence à une température d'au moins environ 85°C.

6. Procédé selon la revendication 1, dans lequel la surface inorganique est exposée à l'agent de décapage chimique pendant un temps suffisant pour conférer à la surface inorganique une concentration de contaminant métallique de tout au plus environ 600 ppm, telle que mesurée par SIMS à une profondeur d'environ 10 nm.

7. Procédé selon la revendication 1, dans lequel la surface inorganique est exposée à l'agent de décapage chimique pendant un temps suffisant pour conférer une concentration superficielle de contaminants métalliques autres que des métaux alcalins et alcalino-terreux de tout au plus environ 400 ppm, telle que mesurée par SIMS à une profondeur d'environ 10 nm.

8. Procédé selon la revendication 1, dans lequel la surface inorganique est exposée à l'agent de décapage chimique pendant un temps suffisant pour conférer à la surface inorganique une concentration de contaminants de fer de tout au plus environ 225 ppm, telle que mesurée par SIMS à une profondeur d'environ 10 nm.

9. Procédé selon la revendication 1, dans lequel l'agent de décapage chimique comprend un fluide supercritique.

10. Procédé selon la revendication 1, dans lequel la surface est exposée au flux de pastilles de CO₂ congelées pendant un temps suffisant pour conférer une contamination par particules de la surface de tout au plus environ 0,4 particules plus grandes qu'environ 0,3 µm par centimètre carré.

11. Procédé selon la revendication 1, dans lequel il n'est pas réalisé d'étape de nettoyage additionnelle entre la fin du flux de pastilles de CO₂ congelées et soit l'installation du composant de traitement de semi-conducteurs dans le four, soit l'emballage du composant de traitement de semi-conducteurs.

12. Procédé selon la revendication 1, dans lequel ladite au moins une couche de matériau additionnelle comprend une couche de polysilicium, une couche d'oxyde de silicium, une couche de nitrure de silicium, une couche métallique, une couche de photorésist et des combinaisons de ces dernières.

13. Procédé selon la revendication 1, dans lequel, après que ladite couche de matériau additionnelle soit déposée sur la surface inorganique, la couche déposée est soumise à un processus comprenant les étapes consistant à:
a) exposer ladite au moins une couche de matériau additionnelle à un agent de décapage chimique, et
b) diriger un flux de pastilles de CO₂ congelées vers la surface inorganique.

14. Procédé selon la revendication 1, dans lequel le composant de traitement de semi-conducteurs est placé de manière étanche dans l'emballage convenant pour l'entreposage et le transport, et qui comprend par ailleurs le fait d'enlever le composant de l'emballage et d'installer le composant de traitement de semi-conducteurs dans un four utilisé pour le traitement de plaquettes semi-conductrices.

15. Procédé selon la revendication 14, dans lequel il n'est pas réalisé d'étape de nettoyage additionnelle entre l'enlèvement du composant de traitement de semi-conducteurs de l'emballage et son installation dans le four.

16. Procédé selon la revendication 1, dans lequel, avant l'étape d'exposition de la surface inorganique à l'agent de décapage chimique, le composant est soumis à un sablage par du SiC vert.

17. Procédé selon la revendication 1, dans lequel la surface inorganique est choisie dans le groupe composé de Si, diamant, Y₂O₃, ZrO₂, SiC, Si₃N₄, AlN, Al₂O₃ et quartz polycristallin ou fondu.

18. Procédé selon la revendication 1, dans lequel la surface inorganique présente un revêtement y déposé en phase vapeur, et dans lequel le matériau déposé en phase vapeur est de préférence choisi dans le groupe composé de Si CVD, SiO₂ CVD, SiC CVD, Si₃N₄ CVD, diamant CVD, Y₂O₃ et ZrO₂.

19. Procédé selon la revendication 1, dans lequel la surface inorganique comprend un revêtement prévu par dépôt par pulvérisation cathodique ou revêtement par pulvérisation.

20. Procédé selon la revendication 1, dans lequel, après avoir prévu ladite au moins une couche de matériau additionnelle, il n'est pas réalisé d'étape de nettoyage additionnelle avant que le composant ne soit installé dans le four utilisé pour le traitement de plaquettes semi-conductrices.

21. Procédé selon la revendication 1, dans lequel il n'est pas réalisé d'étape de nettoyage additionnelle entre la prévision de ladite au moins une couche de matériau additionnelle et l'emballage du composant de traitement de semi-conducteurs.

22. Procédé selon la revendication 1, dans lequel le composant de traitement de semi-conducteurs comprend une structure de SiC poreuse chargée de Si.

23. Procédé selon la revendication 22, dans lequel le composant de traitement de semi-conducteurs est pourvu d'une couche de SiC déposée par des méthodes de CVD.
